Europäisches Patentamt

European Patent Office

Office européen des brevets

(19)

(11) Veröffentlichungsnummer: **0 263 301 B1**

## EUROPÄISCHE PATENTSCHRIFT

(45) Veröffentlichungstag der Patentschrift: **25.03.92**

(51) Int. Cl.⁵: **G03F 7/027**

(21) Anmeldenummer: **87112676.9**

(22) Anmeldetag: **31.08.87**

(54) **Verfahren zur Herstellung von Aufzeichnungsschichten und deren Verwendung zur Herstellung von Flexodruckformen.**

(30) Priorität: **06.09.86 DE 3630474**

(43) Veröffentlichungstag der Anmeldung:
**13.04.88 Patentblatt 88/15**

(45) Bekanntmachung des Hinweises auf die
Patenterteilung:
**25.03.92 Patentblatt 92/13**

(84) Benannte Vertragsstaaten:
**BE CH DE ES FR GB IT LI NL SE**

(56) Entgegenhaltungen:
**DE-A- 2 456 439**
**DE-A- 2 942 183**
**FR-A- 2 308 127**
**US-A- 4 046 577**

(73) Patentinhaber: **BASF Akfiengesellschaft**
**Carl-Bosch-Strasse 38**
**W-6700 Ludwigshafen(DE)**

(72) Erfinder: **Kurtz, Karl-Ruldof, Dr.**
**Schloss-Wolfs-Brunnen-Weg 62**
**W-6900 Heidelberg(DE)**
Erfinder: **Koch, Horst, Dr.**
**Tiefenthaler Strasse 47**
**W-6718 Gruenstadt(DE)**
Erfinder: **Schulz, Guenther, Dr.**
**Wasgaustrasse 24**
**W-6700 Ludwigshafen(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft ein Verfahren zur herstellung einer Flexodruckplatte mit einem dimensionsstabilen Träger und einer ozonresistenten photopolymerisierten Reliefschicht aus einem lichtempfindlichen Aufzeichnungselement mit einem dimensionsstabilen Träger und einer lichtempfindlichen Aufzeichnungsschicht.

Die Flexodruckplatten mit einem dimensionsstabilen Träger und einer ozonresistenten photopolymerisierten Reliefschicht werden im folgenden der Kürze halber als Flexodruckplatten bezeichnet.

Photopolymerschichten und deren Verwendung zur Herstellung von Flexodruckplatten für den Flexodruck sind bekannt und beispielsweise in EP 64 564, DE-B-22 15 090, DE-A-24 56 439, DE-A-29 42 183, DE-A-21 38 582 und DE-A-24 44 118 beschrieben. Derartige Photopolymerschichten für Flexodruckplatten enthalten im allgemeinen elastomere Bindemittel, ein oder mehrere damit verträgliche photopolymerisierbare Monomere, weichmachende Komponenten, Photoinitiatoren sowie weitere Hilfs- und Zusatzstoffe.

Die Monomeren bewirken bei der Photovernetzung eine Löslichkeitsdifferenzierung, so daß nach der bildmäßigen Belichtung die nicht belichteten Teile der Flexodruckplatte mit Lösungsmitteln ausgewaschen werden können, in denen das Bindemittel und nicht polymerisierte Monomere löslich bzw. quellbar sind.

Nachteilig ist hierbei, daß die belichtete Flexoklischees bei Dehnung und bei Lagerung verspröden. Diese Versprödung führt zu einer Verschlechterung der mechanischen Eigenschaften und zu einer erhöhten Anfälligkeit gegenüber Flexodruckfarben und dem Ozongehalt der Luft. Damit ist die Anwendbarkeit derartiger Druckplatten erheblich eingeschränkt.

Um die mechanischen Eigenschaften zu verbessern, werden den Platten weichmachende Füllstoffe zugesetzt, die dafür sorgen, daß die Flexodruckplatte auch nach der Belichtung die notwendige Flexibilität besitzt. Solche Weichmacher sind üblicherweise gesättigte, langkettige Alkane oder Ester aromatischer Dicarbonsäuren. Sie haben den Nachteil, daß sie durch Lösungsmittel, wie sie zum Entwickeln der Flexodruckplatte benötigt werden, extrahiert werden können oder im Lauf der Zeit an die Oberfläche des Flexoklischees diffundieren und dort ausschwitzen Können. Dadurch werden die mechanischen Eigenschaften der Flexodruckplatten beim Entwickeln und der Lagerung wieder verschlechtert. Darüber hinaus kommt es insbesondere bei der Verwendung größerer Weichmachermengen während des Entwicklungsvorganges insbesondere in Bürstenwaschern zu Reliefbeschädigungen. Für die zur Erhöhung des Ozonschutzes verwendeten Wachse gilt im Prinzip das gleiche.

Aus der DE-A-29 42 183 waren auch bereits photopolymerisierbare Gemische und Elemente daraus bekannt, die

a) wenigstens 40 Gew.% mindestens eines in einem Entwicklerlösungsmittel löslichen elastomeren Blockcopolymerisats mit einem thermoplastischen nicht-elastomeren Polymerblock A und einem elastomeren Dien-Polymerblock B

b) wenigstens 1 Gew.% mindestens eines mit dem Blockcopolymerisat (a) verträglichen fotopolymerisierbaren olefinisch ungesättigten Monomeren und

c) 0.1 bis 10 Gew.% mindestens eines Fotopolymerisationsinitiators.

enthalten, wobei das Blockcopolymerisat (a) ein elastomeres Blockcopolymerisat der Struktur A-B-C ist, wobei

a1) der 5 bis 25 Gew.% des Blockcopolymerisats ausmachende Polymerblock A aus mindestens einem der Styrol-Monomeren der Formel $CH_2 = CRR'$ mit R = Wasserstoff oder Methyl, R' = Phenyl oder $C_1$-$C_4$-alkylsubstituiertes Phenyl hergestellt ist und eine Einfriertemperatur (Glastemperatur) über +25°C hat,

a2) der 15 bis 90 Gew.% des Blockcopolymerisats ausmachende Polymerblock B aus mindestens einem aliphatischen Dienkohlenwasserstoff mit 4 bis 5 C-Atomen hergestellt ist und eine Einfriertemperatur (Glastemperatur) unter -20°C hat, und

a3) der 5 bis 60 Gew.% des Blockcopolymerisats ausmachende Polymerblock C durch Homo- oder Copolymerisation mindestens eines Dienkohlenwasserstoffs mit 4 bis 5 C-Atomen hergestellt ist und eine Einfriertemperatur (Glastemperatur) zwischen -30°C und +15°C hat.

Als photopolymerisierbare olefinisch ungesättigte Monomeren, die hier in Mengen von 1 bis 40 Gew.% verwendet werden, werden hier Ester der Acrylsäure und/oder Methacrylsäure mit ein- oder mehrwertigen Alkoholen, wie Butyl(meth)acrylat, 2-Ethylhexylacrylat, Lauryl(meth)acrylat, Ethylenglykoldimethacrylat, Butandiol-1,4-di(meth)acrylat u.a. sowie Mischungen dieser Monomeren genannt. Aus diesen Gemischen können durch Pressen, Extrudieren und Kalandrieren Schichten hergestellt werden. Die aus diesen Gemischen erhaltenen Flexodruckplatten zeigen jedoch oftmals eine ungenügende Isotropie, die sich störend im Druckergebnis auswirken kann.

Aufgabe der vorliegenden Erfindung war es, möglichst isotrope flexible Aufzeichnungsschichten, sowie

2

daraus Flexodruckplatten mit verbesserten Kohäsionseigenschaften herzustellen, die beim Drucken nicht zur Versprödung neigen und gegenüber Druckfarben sowie dem Ozongehalt der Umgebung stabiler sind.

Überraschenderweise wurde gefunden, daß sich durch anteilige Mitverwendung bestimmter Mengen von mit dem elastomeren Bindemittel verträglichen photopolymerisierbaren, monoolefinisch ungesättigten organischen Verbindungen diese Aufgabe gelöst werden kann.

Gegenstand der vorliegenden Erfindung ist ein Verfahren zur Herstellung einer Flexodruckplatte mit einem dimensionsstabilen Träger und einer ozonresistenten Photopolymerisierten Reliefschicht aus einem lichtempfindlichen Aufzeichnungselement mit einem dimensionsstabilen Träger und einer lichtempfindlichen Aufzeichnungsschicht durch

(1) Aufbringen eines lichtempfindlichen Gemischs aus

(A) mindestens einem elastomeren Bindemittel,

(B) einem Gemisch aus mindestens zwei nicht gasförmigen, mit (A) verträglichen, photopolymerisierbaren, olefinisch ungesättigten organischen Verbindungen,

(C) mindestens einem Photopolymerisationsinitiator sowie ggf.

(D) weiteren üblichen Hilfs- und Zusatzstoffen

auf einen dimensionsstabilen Träger,

(2) Verarbeiten des lichtempfindlichen Gemischs auf dem dimensionsstabilen Träger zu einer lichtempfindlichen Aufzeichnungsschicht durch Vorzugsrichtungen erzeugende Verarbeitungsprozesse, wodurch ein lichtempfindliches Aufzeichnungselement resultiert,

(3) bildmäßiges Belichten des lichtempfindlichen Aufzeichnungselements mit aktinischem Licht und

(4) Entwickeln des belichteten Aufzeichnungselements mit einem organischen Lösungsmittel, wodurch die Flexodruckplatte resultiert,

wobei das Gemisch (B) aus - jeweils bezogen auf die Gesamtmenge des lichtempfindlichen Gemischs (A) bis (D) - 5 bis 20 Gew.-% mindestens aus einer mit (A) verträglichen, photopolymerisierbaren, mindestens zwei olefinische Doppelbindungen enthaltenden organischen Verbindung (B1) und 1 bis 15 Gew.-% mindestens einer mit (A) verträglichen, monoolefinisch ungesättigten, photopolymerisierbaren organischen Verbindung (B2), deren Homopolymerisat eine Glastemperatur unterhalb der Raumtemperatur aufweist, besteht und daß die photopolymerisierte Reliefschicht bzw. das photopolymerisierte lichtempfindliche Gemisch der lichtempfindlichen Aufzeichnungsschicht des lichtempfindlichen Aufzeichnungselements einen Anisotropiefaktor AF von < 1,5 hat, wobei AF definiert ist als das Verhältnis der Elastizitätsmoduli bei 100 % Dehnung des photopolymerisierten lichtempfindlichen Gemischs längs und quer zu seiner Fließrichtung bei seiner Verarbeitung zur lichtempfindlichen Aufzeichnungsschicht im Verfahrensschritt (2).

Vorzugsweise werden als Komponente (B2) Ester der Acrylsäure mit verzweigten, 4 bis 16 Kohlenstoffatome enthaltenden Monoalkanolen, insbesondere 2-Ethylhexylacrylat, Ester der Acrylsäure mit 6 bis 12 Kohlenstoffatome enthaltenden geradkettigen Monoalkanolen, Amide der Acrylsäure mit 4 bis 16 Kohlenstoffatome enthaltenden Alkylaminen oder auch Vinylalkylether mit 4 bis 18 Kohlenstoffatomen in der Alkylgruppe verwendet.

Die Zusammensetzung des Monomerengemisches (B), insbesondere der Anteil an nicht gasförmigen, mit (A) verträglichen monoolefinisch ungesättigten photopolymerisierbaren organischen Verbindungen, deren Homopolymerisate Glastemperaturen unterhalb der Raumtemperatur aufweisen, ist von wesentlicher Bedeutung. Sofern deren Gewichtsprozentsatz unter 1 % liegt, erhält man anisotrope Flexodruckplatten sowie Reliefschäden beim Auswaschen, während bei einem Anteil von über 15 Gew.% ein zu starker plastischer Fluß der unbelichteten Schicht resultiert. Bevorzugt ist ein Anteil von 2 bis 10, insbesondere 2 bis 8 Gew.% an Komponente (B2) an der Gesamtmenge des lichtempfindlichen Gemisches.

Durch die erfindungsgemäße anteilige Mitverwendung von mit (A) verträglichen, monoolefinisch ungesättigten, photopolymerisierbaren organischen Verbindungen, deren Homopolymerisate Glastemperaturen unterhalb Raumtemperatur (ca. 22°C) aufweisen, gelingt es überraschenderweise, isotrope Druckplatten herzustellen und die mechanischen Eigenschaften der Flexodruckplatten zu verbessern. Derartige Flexodruckplatten zeigen unter gleichen Bedingungen z.B. beim Entwicklungsvorgang im Bürstenwascher weniger Ausbrüche an Reliefteilen als solche aus oben angegebenen Patentschriften.

Überraschend ergab sich weiter, daß der erfindungsgemäße Zusatz der Monomeren (B2) auch die Ozonbeständigkeit von Flexoklischees im Vergleich zu solchen mit inerten Weichmachern verbessert.

Von den üblichen Beschichtungsverfahren, bei denen die Gemische der Komponenten (A) bis (D) auf einen dimensionsstabilen Träger aufgebracht und Vorzugsrichtungen erzeugenden Verarbeitungsprozessen, wie z.B. der Extrusion oder Kalandrier- oder Kaschierprozessen, unterworfen werden, ist es für Flexodruckplatten bekannt, daß diese in Abhängigkeit von der Fließrichtung eine unterschiedliche Punkt- bzw. Linienverbreiterung beim Druck bewirken. Durch einen höheren Monomeranteil (B1) in der Rezeptur wird dieser Befund verstärkt. Durch die erfindungsgemäße Verwendung der Monomeren (B2), insbesondere der oben genannten Acrylester, ergibt sich überraschenderweise eine deutliche Verringerung des anisotropen Druckverhaltens.

Fügt man den in den oben erwähnten Patentschriften beschriebenen Mischungen mehr Monomer (B1) hinzu, so hat dies einen negativen Einfluß auf den Belichtungsspielraum. Der Belichtungsspielraum ist die Zeitspanne zwischen der Belichtungszeit, die nötig ist, ein Gitter mit einer Linienbreite von 50 $\mu$m bei einer Schichtdicke zwischen 700 und 3000 $\mu$m einwandfrei zu versockeln und der Belichtungszeit, bei der ein negativer i-Punkt von 400 $\mu$m Durchmesser noch mindestens eine Tiefe von 70 $\mu$m besitzt. Setzt man aber die Monomeren (B2) der Mischung zu, so bleibt überraschenderweise trotz des dann höheren Monomergehaltes der gewünschte positive Belichtungsspielraum erhalten.

Einen weiteren Vorteil bildet die Tatsache, daß bei dem erfindungsgemäßen Verfahren zur bildmäßigen Belichtung kürzere Belichtungszeiten ausreichen, als dies bei den bekannten Verfahren der Fall ist.

Zu den Komponenten des lichtempfindlichen Gemisches für das erfindungsgemäße Verfahren ist im einzelnen folgendes aufzuführen.

(A) Als elastomere Bindemittel (A) im Sinne der Erfindung werden übliche elastomere Polymerisations-, Polyadditions- und Polykondensations- produkte verstanden, wie z.B. Homopolymerisate von Butadien oder Isopren, Copolymerisate von Butadien mit Isopren, Copolymerisate von Butadien und/oder Isopren mit anderen copolymerisierbaren olefinisch ungesättigten organischen Verbindungen, wie Vinylaromaten, z.B. Styrol, 2-Methylstyrol oder Vinyltoluol, Nitrilen und/oder Estern der Acryl- und/oder Methacrylsäure, wie Acrylnitril, Methacrylnitril, Ester der (Meth)acrylsäure mit 1 bis 8 Kohlenstoffatome enthaltenden Alkanolen.

Geeignete elastomere Bindemittel sind beispielsweise elastomere Blockcopolymere vom Typ A-B-A, wie sie z.B. in den DE-A-22 15 090, DE-A-22 23 808, DE-A-28 15 678 und DE-A-26 10 206 beschrieben sind. Bevorzugt sind solche elastomere Bindemittel (A), die eine Shore A-Härte zwischen 20 und 80 aufweisen.

Insbesondere sind Blockcopolymere des Typs ABC, wie sie in der DE-A-29 42 183 beschrieben sind, als elastomere Bindemittel bevorzugt. Darin ist z.B. A ein thermoplastisches, nicht elastisches Styrol-Polymerisat, B ein elastomeres Butadien- und/oder Isoprenpolymerisat und C ein von B verschiedenes Polymerisat aus Butadien und/oder Isopren sowie gegebenenfalls Styrol.

Komponente (A) wird im allgemeinen in Mengen von 60 bis 93 Gew.%, bezogen auf die Gesamtmenge des lichtempfindlichen Gemisches (A) bis (D) angewendet.

(B) Komponente (B) ist ein Gemisch aus 5 bis 20 Gew.% (B1) mindestens einer mit (A) verträglichen photopolymerisierbaren, mindestens zwei olefinische Doppelbindungen enthaltenden organischen Verbindung und 1 bis 15 Gew.% (B2) mindestens einer mit (A) verträglichen, monoolefinisch ungesättigten photopolymerisierbaren organischen Verbindung, deren Homopolymerisat eine Glastemperatur aufweist, die unterhalb Raumtemperatur liegt.

Beispiele für die Komponente (B1) sind die üblichen (Meth)Acrylsäureester mehrwertiger Alkohole, wie z.B. Ethylenglykoldimethacrylat, Butandiol-1,4-diacrylat, Butandiol-1,4-dimethacrylat, Neopentylglykoldimethacrylat, 3-Methylpentandioldiacrylat, Hexandioldiacrylat, Hexandiol-1,6-dimethacrylat, 1,1,1-Trimethylolpropantriacrylat und -trimethacrylat, Di-, Tri- und Tetrethylenglykoldiacrylat, Tripropylenglykoldiacrylat, Pentaerythrittetraacrylat, sowie deren Gemische. Derartige geeignete Monomere sind auch der DE-A-30 12 841 zu entnehmen.

Komponente (B1) wird in einer Menge von 5 bis 20, vorzugsweise 7 bis 15 Gew.%, bezogen auf die Gesamtmenge des lichtempfindlichen Gemisches (A) bis (D) angewendet.

Beispiele für die Komponente (B2), d.h. monofunktionelle photopolymerisierbare, mit Komponente (A) verträgliche Monomere, deren Homopolymerisate Glastemperaturen unterhalb Raumtemperatur aufweisen, sind enstprechende Ester der Acryl- und Methacrylsäure, wie n-Butylacrylat, Isobutylacrylat, vorzugsweise Ester der Acrylsäure mit verzweigten 4 bis 16 Kohlenstoffatome enthaltenden Monoalkanolen, wie ®Alfol-6,10-acrylat, ®Cadura-E-10-acrylat, 2-Ethylhexylacrylat sowie geradkettigen 6 bis 12 Kohlenstoffatome enthaltenden Monoalkanolen, wie Laurylacrylat. Bei dem ®Alfol-6,10-acrylat der Shell Aktiengesellschaft handelt es sich um einen Ester, welchen man durch Oligomerisierung von Ethylen, Einführung einer OH-Gruppe in das Ethylenoligomere und Veresterung mit Acrylsäure erhält. Bei dem ®Cadura-E-10-acrylat der Shell Aktiengesellschaft handelt es sich um eine tert.-Alkancarbonsäure, deren Alkylrest eine Acrylatgruppe als Substituent aufweist.

Ferner eignen sich Amide der Acrylsäure mit einem 4 bis 16 Kohlenstoffatome enthaltenden Alkylamin, vorzugsweise N-Octylacrylamid, sowie Vinylalkylether mit 4 bis 18 Kohlenstoffatomen in der Alkylgruppe, z.B. Butylvinylether und Hexylvinylether, sowie Gemische der unter (B2) genannten Monomeren.

Weitere geeignete Monomere, deren Homopolymerisate eine Glastemperatur unterhalb der Raumtemperatur besitzen, sind im Polymer Handbook, 2nd Edition, J.Wiley & Sons, New York 1979 aufgeführt.

Der Gehalt solcher Monomerer (B2) im lichtempfindlichen Gemisch der Komponenten (A) bis (D) beträgt zwischen 1 und 15 Gew.%, bevorzugt sind 2 bis 10, insbesondere 2 bis 8 Gew.%, wobei sich die Gewichtsprozente auf die Gesamtmenge des lichtempfindlichen Gemisches (A) bis (D) beziehen.

(C) Als Photoinitiatoren eignen sich die üblichen, beispielsweise Benzoinether, Benzophenone, Thioxanthone, Ketale, wie Benzildimethylketal, Acetophenone und Acylphosphinoxide. Derartige geeignete Photoinitiatoren sind auch den oben genannten Druckschriften zu entnehmen. Bevorzugt ist Benzildimethylketal und Trimethylbenzoyldiphenylphosphinoxid.

Die Photoinitiatoren werden im allgemeinen in Mengen von 0,01 bis 10, vorzugsweise 0,01 bis 5 Gew.% im lichtempfindlichen Gemisch der Komponenten (A) bis (D) verwendet.

(D) Als gegebenenfalls mitzuverwendende weitere Hilfs- und Zusatzstoffe kommen in Frage Inhibitoren der thermischen Polymerisation, Farbstoffe, Pigmente, Lichthofschutzmittel, Flußmittel, photochrome Stoffe, Antiozonantien und -oxidantien, Trennmittel, Weichmacher, Füllmittel und/oder Verstärkerfüllstoffe in wirksamen Mengen.

Besonders bevorzugte Weichmacher sind Chloralkane mit 8 bis 40 Kohlenstoffatomen und einem Chlorgehalt von 30 bis 73 Gew.%, die beispielsweise den lichtempfindlichen Gemischen in Mengen von bis zu 20 Gew.% einverleibt werden können.

Als Verarbeitungshilfsmittel und zur Härteregulierung können beispielsweise oligomere $\alpha$-Methylstyrol/Vinyltoluol-Copolymerisate mit $\overline{M}_n$ ca. 1500 oder oligomere auf Basis Polystyrol mit $\overline{M}_n$ 500 bis 10 000 mitverwendet werden.

Ein geeigneter thermischer Stabilisator ist z.B. 2.6-Di-(tert.-butyl)phenol oder das entsprechende Kresol.

Ferner Können Ozonschutzwachse (z.B. Antilux® 550) Farbstoffe, wie z.B. Farbstoff SSBB (= Sudantiefschwarz) und Cu-Phthalocyanine mitverwendet werden.

Das lichtempfindliche Gemisch der Komponenten (A) bis (D) kann nach bekannten Techniken wie Kneten im Brabender, Extrusion und anschließendes Kalandrieren oder Gießen aus toluolischer Lösung zu homogenen, flächigen Gebilden in einer Schichtdicke zwischen 10 bis 8000 $\mu$m geformt werden. Als Träger für solche Schichten eignen sich dimensionsstabile Träger, z.B. Stahl, Kunststoffolien, Aluminium, Nickel oder andere polymere - auch flexible Trägerschichten. Die Herstellung von Flexoklischees folgt dem üblichen Verarbeitungsgang, d.h. Vorbelichten, bildmäßiges Hauptbelichten, Entwickeln in organischen Lösungsmitteln - bevorzugt Perchlorethylen/ n-Butanol, Trocknen, Herstellung der Klebfreiheit und Nachbelichten.

Die in den folgenden Beispielen und Vergleichsbeispielen angegebenen Teile und Prozente sind, soweit nicht anders angegeben, Gewichtsteile und Gewichtsprozente.

Beispiele 1 bis 5

Herstellung extrudierter lichtempfindlicher Aufzeichnungsschichten

Das elastomere Bindemittel (A) wurde über eine Förderschnecke gleichmäßig in einen Zweischnecken-Extruder eingetragen und bei 140°C aufgeschmolzen. Die flüssigen Komponenten (Monomere (B1) und (B2), Photoinitiator, Farbstoff) wurden nacheinander in den Extruder gepumpt und aus einer Breitschlitzdüse ausgetragen. Mit einer Kalanderwalze wurden 2900 $\mu$m Aufzeichnungsschichten zwischen einer 125 $\mu$m Polyesterfolie und einem Polyamidsubstrat hergestellt.

Tabelle 1

| Beisp. Nr. | (A) % | (B1) % | (B2) Typ | % | Photoinitiator % | Farbstoff % | therm. Stabilisator % | Ozonschutzwachs % | $\alpha$-Methylstyrol/ Vinyltoluol-Copolymer ($\overline{M}_n$ 500) % |
|---|---|---|---|---|---|---|---|---|---|
| 1 | 82 | 6 | ®Alfol-6, 10-acrylat[a] | 6 | 1 | 0,005 | 1 | 1 | 3 |
| 2 | 82 | 6 | Isobutylacrylat | 6 | 1 | 0,005 | 1 | 1 | 3 |
| 3 | 82 | 6 | 2-Ethylhexylacrylat | 6 | 1 | 0,005 | 1 | 1 | 3 |
| 4 | 82 | 6 | Laurylacrylat | 6 | 1 | 0,005 | 1 | 1 | 3 |
| 5 | 82 | 6 | ®Cadura-E-10-acrylat[a] | 6 | 1 | 0,005 | 1 | 1 | 3 |

Herstellung von lichtempfindlichen Aufzeichnungsschichten mit lichtempfindlichen Gemischen folgender Zusammensetzungen:

(B1) = Monomermischung aus 4 % HDA2 + 2 % HDMA2;

Photoinitiator = Benzildimethylkatal;

Farbstoff = Farbstoff SSBB = Sudantiefschwarz;

therm. Stabilisator = 2,6-Di-(t-butyl)kresol;

Ozonschutzwachs (Antilux 550);

(A) = Blockcopolymerisat, ABC (s. Beschreibung, gemäß DE-A-29 42 183);

HDA2 = Hexandioldiacrylat;

HDMA2 = Hexandioldimethacrylat;

[a] Hersteller: Shell Aktiengesellschaft;

Die erhaltenen lichtempfindlichen Aufzeichnungsschichten wurden 2 Minuten durch die Polyesterfolie in einem Röhrenbelichter vollflächig vorbelichtet, anschließend durch ein auf die Substratschicht aufgelegtes Negativ bildmäßig belichtet, und in einem Bürstenwascher mit einem Perchlorethylen/n-Butanol (4:1)-Gemisch 6 Minuten lang entwickelt. Die Flexodruckplatte wurde 1 Stunde bei 65°C getrocknet und nach einer Ruhezeit von 15 Stunden einer Behandlung mit wäßriger Bromlösung zur Erzielung der Klebfreiheit unterworfen und 10 Minuten lang nachbelichtet. Es wurden einwandfreie Flexodruckplatten erhalten, die auf Druckzylindern ausgezeichnete Druckergebnisse lieferten.

Gießschichten

Lichtempfindliche Aufzeichnungsschichten mit der in der Tabelle 2 aufgelisteten Zusammensetzung wurden durch Lösen der entsprechenden Komponenten in Toluol und Aufbringen der 30 %igen Lösung auf eine 125 $\mu$m dicke Polyesterfolie mit Polyurethan-Haftlack hergestellt. Nach dem Trocknen wurde eine Schicht mit 1000 $\mu$m Dicke erhalten. Es wurde eine 75 $\mu$m dicke, substrierte Deckfolie aufkaschiert, die Folie entfernt und die Schicht durch das auf der Oberfläche verbleibende Substrat durch ein Negativ belichtet. Nach dem Entwickeln wie oben beschrieben wurde ein Reliefbild mit einer Höhe von 700 $\mu$m erhalten, das den transparenten Bereichen des Negativs entsprach.

7

Tabelle 2

| | | | | | | | | |
|---|---|---|---|---|---|---|---|---|
| Herstellung von lichtempfindlichen Aufzeichnungsschichten durch Gießen | | | | | | | | |
| Beisp. Nr. | (A) % | (B1) % | (B2) Typ | % | Photoinitiator % | Farbstoff % | therm. Stabilisator % | $\alpha$-Methylstyrol/ vinyltoluol-Copolymer ($\overline{M}_n$ 1500) % |
| 6 | 80 | 7,0 | ®Alfol-6, 10-acrylat[a] | 6 | 1,5 | 0,005 | 1,5 | 4 |
| 7 | 80 | 7,0 | Isobutylacrylat | 6 | 1,5 | 0,005 | 1,5 | 4 |
| 8 | 80 | 7,0 | 2-Ethylhexylacrylat | 6 | 1,5 | 0,005 | 1,5 | 4 |
| 9 | 80 | 7,0 | Laurylacrylat | 6 | 1,5 | 0,005 | 1,5 | 4 |
| 10 | 80 | 7.0 | ®Cadura-E-10-acrylat[a] | 6 | 1,5 | 0,005 | 1,5 | 4 |

[a] Hersteller: Shell Aktiengesellschaft:

Die einzelnen Komponenten wurden in Toluol gelöst (Endkonz. 30 %), zu den übrigen Angaben siehe die Tabelle 1.

Die so erhaltenen Flexodruckplatten lieferten ausgezeichnete Druckergebnisse.

Beispiel 11

Entsprechend Beispiel 8 wurde eine Gießlösung hergestellt. Diese wurde auf eine Stahlplatte (Dicke 240 $\mu$m) gegossen. Nach dem Trocknen der Aufzeichnungsschicht (Schichtdicke: 700 $\mu$m) und dem Entwickeln nach bekannten Methoden wurden Flexodruckplatten erhalten, bei denen das Reliefbild den belichteten Stellen der Schicht entsprach. Das Eigenschaftsprofil ist mit den in Beispiel 8 beschriebenen Schichten vergleichbar.

Vergleichsbeispiel 1

Entsprechend Beispiel 1 wurde eine lichtempfindliche Aufzeichnungsschicht durch Extrusion hergestellt, bei der das Monomere (B2) durch den inerten Weichmacher Weißöl S 5000 ersetzt worden war. Die derart erhaltene Schicht wurde in ihrer Ozonbeständigkeit und in ihrem Anisotropieverhalten untersucht. Dazu wurden vollflächig belichtete Streifen von 2 x 10 cm unter 10 % Längendehnung einer Ozonkonzentration von 50 pphm ausgesetzt und die Zeit bis zum Erscheinen erster Risse notiert. Die Ergebnisse sind in Tabelle 3 enthalten.

Ebenso wurde ein Anisotropiefaktor AF mit Hilfe von vollflächig belichteten Streifen, von 2 x 15 cm, die längs bzw. quer zur Fließrichtung bei der Rohplattenherstellung gestanzt wurden, definiert:

$$AF = \frac{\text{E-Modul (100 \% Dehnung) längs zur Fließrichtung}}{\text{E-Modul (100 \% Dehnung) quer zur Fließrichtung}}$$

Des weiteren wurde die untere Belichtungsgrenze (UBG) angegeben. Das ist die Zeit, die die Schicht mindestens aktinischem Licht ausgesetzt sein muß, um ein Gitter mit 50 $\mu$m breiten Linien ausreichend zu versockeln.

In einer weiteren Spalte sind die Extraktionsverluste durch Lagerung in Ethanol/Essigester 7:3 nach 24 Stunden angegeben.

Die Stärke der Reliefbeschädigungen bei gleichen Auswaschbedingungen sind in der letzten Spalte enthalten.

Tabelle 3

| Ozonbeständigkeit und Anisotropieverhalten von Flexodruckplatten | | | | | | |
|---|---|---|---|---|---|---|
| Beispiel Nr. | Weichmacher bzw. mit (B2) | Rißfreiheit Minuten | AF | UBG[a] Minuten | Extr.verl. % | Reliefausbr. 50 $\mu$m Gitter |
| Vergleichsbeispiel 1 | Weißöl S 5000 | < 10 | 1,6 | 22 | 4,56 | - |
| 1 | ®Alfol-6,10-acrylat[b] | 30-40 | 1,4 | 14 | 2,73 | + |
| 2 | Isobutyl-acrylat | 30-40 | 1,3 | 14 | 2,44 | + |
| 3 | 2-Ethyl-hexylacrylat | 50-60 | 1,1 | 16 | 2,71 | + |
| 4 | Lauryl-acrylat | 20-30 | 1,4 | 18 | 3,07 | o |
| 5 | ®Cadura-E-10-acrylat[b] | >19h | 1.4 | 18 | 2.86 | o |

[a] UBG: Untere ßelichtungsgrenze (50 $\mu$m Gitterlinie);
Reliefausbrüche an Gitterelementen von 50 $\mu$m Linienbreite,
Bewertung: - schlecht, o wenig, + gut;
[b] Hersteller: Shell Aktiengesellschaft;

Vergleichsbeispiel 2

Entsprechend Beispiel 6 wurde eine lichtempfindliche Aufzeichnungsschicht durch Gießen hergestellt, bei der das Monomer (B2) durch den inerten Weichmacher Weißöl S 5000 ersetzt worden war. Die untere Belichtungsgrenze einer solchen Aufzeichnungsschicht wurde mit denen der entsprechenden Flexodruckplatten mit verschiedenen Monomeren (B2) verglichen (s. Tabelle 4).

Tabelle 4

| Belichtungseigenschaften lichtempfindlicher Aufzeichnungsschichten mit inertem Weichmacher, bzw. verschiedenen Monomeren (B2) | | |
|---|---|---|
| Beispiel Nr. | Weichmacher | UBG Minuten |
| Vergleichsbeispiel 2 | Weißöl S 5000 | 18 |
| 6 | ®Alfol-6,10-acrylat[a] | 14 |
| 7 | Isobutylacrylat | 12 |
| 8 | 2-Ethyl-hexylacrylat | 14 |
| 9 | Lauryl-acrylat | 16 |
| 10 | ®Cadura-E-10-acrylat[a] | 14 |

[a] Hersteller: Shell Aktiengesellschaft;

Beispiel 14

Analog der Herstellungsweise unter C) wurden folgende Komponenten mit Hilfe eines Extruders gemischt und lichtempfindliche Aufzeichnungsschichten mit einer Dicke von 2900 $\mu$m hergestellt.

| | |
|---|---|
| 75 % | (A) |
| 4 % | Hexandioldiacrylat (B1), |
| 2 % | Hexandioldimethacrylat (B1), |
| 3 % | Trimethylolpropantriacrylat (B1), |
| 3 % | i-Butylacrylat (B2), |
| 9 % | Chloralkangemisch (8 bis 40 C-Atome; Cl-Gehalt: 49 %; Viskosität ca. 10 000 mPas bei 25°C), |
| 1,5 % | Benzildimethylketal, |
| 1 % | therm. Stabilisator (wie Tabelle 1), |
| 1,5 % | Ozonschutzwachs und |
| 0,005 % | Farbstoff SSBB (Sudantiefschwarz). |

Nach dem Kaschieren auf eine 125 $\mu$m Trägerfolie und dem Aufbringen eines Substrates wurden die Platten durch ein Negativ bildmäßig belichtet und nach üblichen Methoden Flexodruckplatten hergestellt.

Die derart hergestellten Flexodruckplatten zeichneten sich durch eine hohe Ozonresistenz, positiven Belichtungsspielraum und kurze Belichtungszeiten aus.

Beispiel 15

Ein Gemisch aus 69 Teilen des in Beispiel 1 genannten Blockcopolymerisats ABC, 12,9 Teilen des in Beispiel 14 genannten Weichmachers auf Chloralkanbasis, 6,7 Teilen Hexandioldiacrylat. 3,3 Teilen Hexandioldimethacrylat, 1,0 Teilen des in Beispiel 1 genannten thermischen Stabilisators, 1,2 Teilen Trimethylbenzoyldiphenylphosphinoxid, 0,006 Teilen eines Cu-Phthalocyanin-Farbstoffs (Sicoflush H grün 8730), 1,0 Teil Ozonschutzwachs, 2,5 Teilen 2-Ethylhexylacrylat und 2.5 Teilen des in Beispiel 1 genannten $\alpha$-Methylstyrol/Vinyltoluol-Copolymerisats($M_n$ 1500) wurde wie in Beispiel 1 beschrieben extrudiert. Die daraus erhaltene photopolymerisierte Reliefschicht wies einen Anisotropiefaktor (100 %) AF = 1,0 auf.

Vergleichsbeispiel 3

Ein Gemisch, das sich von dem des Beispiels 15 nur dadurch unterschied, daß anstelle von 2,5 Teilen 2-Ethylhexylacrylat und 2,5 Teilen des $\alpha$-Methylstyrol/Vinyltoluol-Copolymerisats $\overline{M}_n$ 1500) 5,0 Teile des $\alpha$-Methylstyrol/Vinyltoluol-Copolymerisats - also ohne Zusatz eines Monomeren (B2) - verwendet wurde, wurde wie in Beispiel 1 beschrieben extrudiert. Die so erhaltene photopolymerisierte Reliefschicht wies einen Anisotropiefaktor (100 %) AF = 2,4 auf. Daraus hergestellte Flexodruckplatten zeigten ein ungenügendes Druckverhalten,

**Patentansprüche**

1. Verfahren zur Herstellung einer Flexodruckplatte mit einem dimensionsstabilen Träger und einer ozonresistenten photopolymerisierten Reliefschicht aus einem lichtempfindlichen Aufzeichnungselement mit einem dimensionsstabilen Träger und einer lichtempfindlichen Aufzeichnungsschicht durch

 (1) Aufbringen eines lichtempfindlichen Gemischs aus

  (A) mindestens einem elastomeren Bindemittel,

  (B) einem Gemisch aus mindestens zwei nicht gasförmigen, mit (A) verträglichen, photopolymerisierbaren, olefinisch ungesättigten organischen Verbindungen,

  (C) mindestens einem Photopolymerisationsinitiator sowie ggf.

  (D) weiteren üblichen Hilfs- und Zusatzstoffen

 auf einen dimensionsstabilen Träger,

 (2) Verarbeiten des lichtempfindlichen Gemischs auf dem dimensionsstabilen Träger zu einer lichtempfindlichen Aufzeichnungsschicht durch Vorzugsrichtungen erzeugende Verarbeitungsprozesse, wodurch ein lichtempfindliches Aufzeichnungselement resultiert,

 (3) bildmäßiges Belichten des lichtempfindlichen Aufzeichnungselements mit aktinischem Licht und

 (4) Entwickeln des belichteten Aufzeichnungselements mit einem organischen Lösungsmittel, wodurch die Flexodruckplatte resultiert,

dadurch gekennzeichnet, daß hierbei das Gemisch (B) aus, jeweils bezogen auf die Gesamtmenge des lichtempfindlichen Gemischs (A) bis (D), 5 bis 20 Gew.-% mindestens einer mit (A) verträglichen, photopolymerisierbaren, mindestens zwei olefinische Doppelbindungen enthaltenden organischen Verbindung (B1) und 1 bis 15 Gew.-% mindestens einer mit (A) verträglichen, monoolefinisch ungesättigten, photopolymerisierbaren organischen Verbindung (B2), deren Homopolymerisat eine Glastemperatur unterhalb der Raumtemperatur aufweist, besteht und daß die photopolymerisierte Reliefschicht bzw. das photopolymerisierte lichtempfindliche Gemisch der lichtempfindlichen Aufzeichnungsschicht des lichtempfindlichen Aufzeichnungselements einen Anisotropiefaktor AF von < 1;5 hat, wobei AF definiert ist als das Verhältnis der Elastizitätsmoduli bei 100 % Dehnung des photopolymerisierten lichtempfindlichen Gemischs längs und quer zu seiner Fließrichtung bei seiner Verarbeitung zur lichtempfindlichen Aufzeichnungsschicht im Verfahrensschritt (2).

2. Das Verfahren nach Anspruch 1, dadurch gekennzeichnet, daß man als monoolefinisch ungesättigte photopolymerisierbare organische Verbindung (B2) einen Ester der Acrylsäure mit einem verzweigten, 4 bis 16 Kohlenstoffatome enthaltenden Monoalkanol verwendet.

3. Das Verfahren nach Anspruch 1, dadurch gekennzeichnet, daß man als monoolefinisch ungesättigte photopolymerisierbare organische Verbindung (B2) einen Ester der Acrylsäure mit einem 6 bis 12 Kohlenstoffatome enthaltenden geradkettigen Monoalkanol verwendet.

4. Das Verfahren nach Anspruch 1, dadurch gekennzeichnet, daß man als monoolefinisch ungesättigte, fotopolymerisierbare organische Verbindung (B2) ein Amid der Acrylsäure mit einem 4 bis 6 Kohlenstoffatome enthaltenden Alkylamin oder einen Vinylalkylether mit 4 bis 18 Kohlenstoffatomen in der Alkylgruppe verwendet.

5. Das Verfahren nach einem der Ansprüche 1 bis 4, dadurch gekennzeichnet, daß das Gemisch (B) aus, jeweils bezogen auf die Gesamtmenge des lichtempfindlichen Gemischs (A) bis (D), 7 bis 15 Gew.-% der Komponente (B1) und 2 bis 10 Gew.-% der Komponente (B2) besteht.

6. Das Verfahren nach einem der Ansprüche 1 bis 5, dadurch gekennzeichnet, daß man hierbei nach dem Verfahrensschritt (2) Streifen der Abmessungen 2 x 15 cm aus der lichtempfindlichen Aufzeichnungsschicht längs und quer zur Fließrichtung des zur Herstellung der lichtempfindlichen Aufzeichnungsschicht verwendeten lichtempfindlichen Gemischs ausstanzt, die hierbei erhaltenen Streifen vollflächig mit aktinischem Licht belichtet, an den belichteten Streifen den Elastizitätsmodul bei 100 % Dehnung längs zur Fließrichtung und den Elastizitätsmodul bei 100 % Dehnung quer zur Fließrichtung bestimmt und hiernach aus den erhaltenen Werten den Anisotropiefaktor AF errechnet.

**Claims**

1. A process for the preparation of a flexographic printing plate having a dimensionally stable substrate and an ozone-resistant photopolymerized relief layer from a photosensitive recording element having a dimensionally stable substrate and a photosensitive recording layer by
    (1) applying a photosensitive mixture of
        (A) one or more elastomeric binders,
        (B) a mixture of two or more nongaseous, photopolymerizable, olefinically unsaturated organic compounds which are compatible with (A), and
        (C) one or more photopolymerization initiators, with or without
        (D) other conventional assistants and additives
    to a dimensionally stable substrate,
    (2) processing the photosensitive mixture on the dimensionally stable substrate to give a photosensitive recording layer by processes which produce preferred directions, resulting in a photosensitive recording element,
    (3) imagewise exposure of the photosensitive recording element to actinic light and
    (4) development of the exposed recording element with an organic solvent, resulting in the flexographic printing plate,
    wherein the mixture (B) consists of from 5 to 20% by weight of one or more photopolymerizable organic compounds (B1) which are compatible with (A) and contain two or more olefinic double bonds and from 1 to 15% by weight of one or more monoolefinically unsaturated, photopolymerizable organic compounds (B2) which are compatible with (A) and whose homopolymer has a glass transition temperature below room temperature, the percentages in each case being based on the total amount of the photosensitive mixture (A) to (D), and the photopolymerized relief layer or the photopolymerized photosensitive mixture of the photosensitive recording layer of the photosensitive recording element has an anisotropy factor AF of < 1.5, AF being defined as the ratio of the moduli of elasticity at 100% elongation of the photopolymerized photosensitive mixture along and crosswise to its direction of flow when it is being processed to give a photosensitive recording layer in process step (2).

2. A process as claimed in claim 1, wherein an ester of acrylic acid with a branched monoalkanol of 4 to 16 carbon atoms is used as the monoolefinically unsaturated photopolymerizable organic compound (B2).

3. A process as claimed in claim 1, wherein an ester of acrylic acid with a straight-chain monoalkanol of 6 to 12 carbon atoms is used as the monoolefinically unsaturated photopolymerizable organic compound (B2).

4. A process as claimed in claim 1, wherein an amide of acrylic acid with an alkylamine of 4 to 6 carbon atoms or a vinyl alkyl ether where the alkyl group is of 4 to 18 carbon atoms is used as the monoolefinically unsaturated photopolymerizable organic compound (B2).

5. A process as claimed in any of claims 1 to 4, wherein the mixture (B) consists of from 7 to 15% by weight of component (B1) and from 2 to 10% by weight of component (B2), the percentages in each case being based on the total amount of the photosensitive mixture (A) to (D).

6. A process as claimed in any of claims 1 to 5, wherein, after process step (2), strips having the dimensions 2 x 15 cm are punched from the photosensitive recording layer longitudinally and crosswise with respect to the direction of flow of the photosensitive mixture used for the production of the photosensitive recording layer, the strips obtained are exposed uniformly to actinic light, the modulus of elasticity at 100% elongation along the direction of flow and the modulus of elasticity at 100% elongation crosswise to the direction of flow are determined for the exposed strips, and the anisotropy factor AF is then calculated from the values obtained.

**Revendications**

1.  Procédé de confection d'un cliché flexographique comportant un support doué de stabilité dimensionnelle et une couche à reliefs photopolymérisée, résistant à l'ozone, constitué d'un élément d'enregistrement sensible à la lumière avec support doué de stabilité dimensionnelle et couche d'enregistrement sensible à la lumière,
    (1) en appliquant un mélange sensible à la lumière composé
    (A) d'au moins un liant élastomère,
    (B) d'un mélange en au moins deux composés organiques photopolymérisables, non gazeux, à insaturation oléfinique, compatibles avec (A),
    (C) d'au moins un initiateur de photopolymérisation, ainsi que, éventuellement,
    (D) d'autres auxiliaires et additifs,
    sur un support doué de stabilité dimensionnelle,
    (2) en soumettant le mélange sensible à la lumière, sur le support doué de stabilité dimensionnelle, en vue d'obtenir une couche d'enregistrement sensible à la lumière, à des processus de traitement produisant des directions préférentielles d'où résulte un élément d'enregistrement sensible à la lumière.
    (3) en exposant l'élément d'enregistrement sensible à la lumière, selon le sujet-image, à une lumière actinique et
    (4) en développant l'élément d'enregistrement ainsi exposé avec un solvant organique, d'où résulte le cliché flexographique,
    caractérisé par le fait que le mélange (3) est constitué, rapporté dans chaque cas à la totalité du mélange (A) à (D) sensible à la lumière, de 5 à 20 % en poids d'au moins un composé organique (B1) photopolymérisable, compatible avec (A), contenant au moins deux doubles liaisons oléfiniques, et de 1 à 15 % en poids d'au moins un composé organique (B2) photopolymérisable, à insaturation monooléfinique, compatible avec (A), dont l'homopolymérisat présente une température de transition vitreuse inférieure à la température ordinaire, et la couche à reliefs photopolymérisée ou le mélange photopolymérisé sensible à la lumière, de la couche d'enregistrement sensible à la lumière de l'élément d'enregistrement sensible à la lumière présente un facteur d'anisotropie AF < 1,5, AF étant défini comme rapport des modules d'élasticité à 100 % d'allongement du mélange photopolymérisé, sensible à la lumière, longitudinalement et transversalement à sa direction d'écoulement lors de son traitement en vue d'obtenir la couche d'enregistrement sensible à la lumière dans l'étape opératoire (2).

2.  Procédé selon la revendication 1, caractérisé par le fait que l'on utilise, comme composé organique (B2) photopolymérisable, à insaturation monooléfinique, un ester de l'acide acrylique et d'un mono = alcanol ramifié contenant 4 à 16 atomes de carbone.

3.  Procédé selon la revendication 1, caractérisé par le fait que l'on utilise, comme composé organique (B2) photopolymérisable, à insaturation monooléfinique, un ester de l'acide acrylique et d'un monoalcanol linéaire contenant 6 à 12 atomes de carbone.

4.  Procédé selon la revendication 1, caractérisé par le fait que l'on utilise, comme composé organique (B2) photopolymérisable, à insaturation monooléfinique, un amide de l'acide acrylique avec une alkylamine contenant 4 à 6 atomes de carbone, ou un éther vinylalkylique à 4 à 18 atomes de carbone dans le groupe alkyle.

5.  Procédé selon l'une des revendications 1 à 4, caractérisé par le fait que le mélange (B) est constitué, rapporté dans chaque cas à la totalité du mélange (A) à (D) sensible à la lumière, de 7 à 15 % en poids du composant (B1 et de 2 à 10 % en poids du composé (B2).

6.  Procédé selon l'une des revendications 1 à 5, caractérisé par le fait qu'après l'étape opératoire (2), on découpe de la couche d'enregistrement sensible à la lumière, longitudinalement et transversalement à la direction d'écoulement du mélange sensible à la lumière utilisé pour produire la couche d'enregistrement sensible à la lumière, des rubans aux dimensions de 2 à 15 cm, on expose lesdits rubans, sur toute leur surface, à une lumière actinique, on détermine sur les rubans exposés le module d'élasticité avec 100 % d'allongement longitudinalement à la direction d'écoulement et le module d'élasticité avec 100 % d'allongement longitudinalement à la direction d'écoulement et le module d'élasticité avec 100 % d'allongement transversalement à la direction d'écoulement et on calcule d'après les valeurs obtenues, on calcule le facteur d'anisotropie AF.